# EUROPEAN PATENT SPECIFICATION

(11) **EP 2 122 417 B1**
(45) Date of publication and mention of the grant of the patent: **15.08.2012**
(21) Application number: 07873494.4
(22) Date of filing: 17.12.2007
(51) Int. Cl.: G03F 7/00, B82Y 30/00, B82Y 10/00, B82B 3/00

(54) **FABRICATION OF MICROSTRUCTURES AND NANOSTRUCTURES USING ETCHING RESIST**
HERSTELLUNG VON MIKROSTRUKTUREN UND NANOSTRUKTUREN UNTER VERWENDUNG VON ÄTZRESIST
FABRICATION DE MICROSTRUCTURES ET NANOSTRUCTURES UTILISANT UNE RÉSERVE DE GRAVURE

(30) Priority: 18.12.2006 US 875447 P; 26.01.2007 US 886839 P
(43) Date of publication of application: 25.11.2009
(73) Proprietor: Northwestern University, Evanston, IL 60208 (US)
(72) Inventor: MIRKIN, Chad, A., Wilmette, IL 60091 (US); HUANG, Ling, Evanston, IL 60201 (US); SANEDRIN, Raymond, Evanston, IL 60201 (US)
(74) Representative: Lahrtz, Fritz
(86) International application number: PCT/US2007/025722
(87) International publication number: WO 2008/121137

(56) References cited:
- WO-A-2006/031079
- US-A- 6 040 002
- US-A1- 2003 152 703
- US-A1- 2007 237 889
- US-A1- 2008 110 363
- SALAITA K.S. ET AL: "DPN-generated Nanostructures as Positive Resists for Preparing Lithographic Masters or Hole Arrays" NANO LETTERS, vol. 6, no. 11, 27 September 2006 (2006-09-27), pages 2493-2498, XP002500251 cited in the application
- WEINBERGER D A ET AL: "COMBINATORIAL GENERATION AND ANALYSIS OF NANOMETER- AND MICROMETER-SCALE SILICON FEATURES VIA DIP PEN NANOLITHOGRAPHY AND WET CHEMICAL ETCHING" ADVANCED MATERIALS, WILEY VCH, WEINHEIM, DE, vol. 12, no. 21, 2 November 2000 (2000-11-02), pages 1600-1603, XP000976740 ISSN: 0935-9648
- NOY A. ET AL: "Fabrication of Luminescent Nanostructures and Polymer Nanowires Using Dip-Pen Nanolithography" NANO LETTERS, vol. 2, no. 2, 21 December 2001 (2001-12-21), pages 109-112, XP002500252
- JIANG, H. AND STUPP, S.I.: "Dip-Pen Patterning and Assembly of Peptide Amphiphiles" LANGMUIR, vol. 21, 10 May 2005 (2005-05-10), pages 5242-5246, XP002500253
- TANG Q ET AL: "Fabrication of highly oriented microstructures and nanostructures of ferroelectric P(VDF-TrFE) copolymer via dip-pen nanolithography" SUPERLATTICES AND MICROSTRUCTURES, ACADEMIC PRESS, LONDON, GB, vol. 36, no. 1-3, 1 July 2004 (2004-07-01), pages 21-29, XP004630793 ISSN: 0749-6036

## Description

### RELATED APPLICATIONS

This application claims the benefit of priority to provisional application Ser. Nos. 60/875,447 filed December 18, 2006 and 60/886,839 filed January 26, 2007 .

### STATEMENT REGARDING FEDERALLY SPONSORED RESEARCH OR DEVELOPMENT

These inventions were developed in part with support from the Army Research Office (ARO) under contract no. 28065-3-A2//W91 1NF-04- 1-07 1 and the National Institute of Health (NIH) under contract no. DPI OD 000285-02. The U.S. government has certain rights in the inventions.

### BACKGROUND

Alkyl thiols and dendrimers have been used as resist molecules for wet chemical etching to generate arbitrary architectures with feature sizes varying from sub-100 nm up to several microns. See, for example, Geissler et al., Adv. Mater. 2004, 16, 1249; Perl et al., Langmuir 2006, 22, 7568; Rolandi et al., Nano Lett. 2004,4, 889; Zhang, et al., Nano Lett. 2003,3,43; and Ducker et al., J. Am. Chem. Soc. 2006, 128, 392.

A basic principle behind this method is to first create a patterned monolayer of alkyl thiol molecule on substrates of interest, and then exposing this substrate to an etch solution. Etching can be achieved either by electrochemical methods, or by thiourea and iron nitrate based etching, whereby different kinds of positive nanostructures could be generated. Alternatively, a thiol based molecule can be first patterned onto a metal substrate (which will be removed later on as a sacrificial molecule) and the unpatterned area backfilled with alkyl thiols. The backfilled alkyl thiols act as etching resist due to their hydrophobicity after the first patterned monolayer is removed by electrochemical desorption. This backfilled alkyl thiol molecule will protect the covered area from being etched by the aqueous based etching solution, which generates the negatively etched nanostructures.

By using dip-pen nanolithography (DPN) printing, the size of the nanostructures can be minimized within 100 nm, and the patterned area can be as large as one square centimeter, while maintaining the sub-100 nm resolution of individual nanostructures. See, for example, Zhang, et al., Nano Lett. 2002, 2, 1389; Salaita et al., Angew. Chem. Int. Ed. 2006,45, 7220; Salaita et al., Small 2005, 1, 940; Salaita et al., Nano Lett. 2006, 6, 2493.

In some cases, this method can involve strong chemical interactions between the thiol group and the noble metal substrates. However, in general, there can be two disadvantages of this method. A first is that even though the positively etched metal architectures are generated, the patterns are still covered by alkyl thiol molecules, which can negatively effect further studies of these nanostructures. Examples of such studies include plasma resonance and surface-enhanced Raman characterization. This alkyl thiol-Au chemical bond can be broken by exposing the sample to the UV light. However, this will create an extra experimental step. In the case of negative etching, electrochemistry is typically utilized in order to desorb the first patterned sacrifical thiol monolayer, which will also affect the density of the backfilled alkyl thiol monolayers, since the desorption potential for these two thiol-molecules are very close. This step negatively effects the thiol monolayer that was used as resist, unless special electrochemical instrument is employed in order to desorb the sacrificial thiol molecules.

US 6,040,002 (Noguchi et al.) describes an etching resist composition with a polymeric compound having etching resist properties without any thiol compounds, wherein said polymeric compound is selected from the group consisting of alkali-soluble polymers of polyether, polyester, or polyurethane, maleic acid addition compounds of rosin or rosin derivatives, and polysaccharides containing a carboxylic group. WO 2006/031079 (Kim et al.) discloses an ink composition for an etching resist comprising an aqueous polymer or polymer emulsion and water, wherein the aqueous polymer is a multi-functional (meta)acryl polymer or urethane (meta)acryl polymer with 3-30 ethoxy or propoxy groups. However, in both methods the etching resist composition is pattern-wise imparted to the surface of substrate by ink-jet printing and therefore, the respective methods are not suitable for the fabrication of microstructures and nanostructures when using an etching resist.

A different method which does neither involve any thiols nor any ink-jet printing is disclosed in US 2003/0152703 A1 (Hammond et al.). In said method composite structures are patterned on a surface via layer-by-layer deposition of thin films, wherein said pattern is formed as a polymer-on-polymer stamped involving the transfer of alternating copolymers of maleic anhydride and polyethylene glycol) functionalized methacrylates to an amino functional surface of a polyelectrolyte multilayer. Accordingly, this method is not suitable to provide an etching resist for the fabrication of micro- or nanostructures.

An interesting direct and effective method of fabricating full-colour OLED arrays on the basis of a micro-contact printing process is disclosed in US 2007/0237889 A1 (Cheng et al.). The key of the process lies in a physisorption-based micro-contact printing process which allows for controlling the thickness of the printed films. However, this document does not disclose any process for a physisorption-based patterning of a surface which may serve as etching resist in the fabrication of micro- or nanostructures.

A need exists for better, more versatile, and convenient resist processes for nanolithography and microlithography.

### SUMMARY

Described herein are, among other things, methods according to the appended claims.

In particular, material can be transferred from nanoscopic tips to a substrate by direct write methods.

Also in particular, the patterning composition may comprise oligomeric or polymeric compounds such as polyethylene glycol (PEG), polyethylene oxide and the like.

Advantages include for at least some embodiments excellent versatility and control. For positive etching, no passivation is needed. For negative etching, patterns can be easily removed. For both types, complicated electrochemical facilities, electrochemistry, or electrodes are not needed and etching is easy to operate.

In some embodiments, it has been discovered that PEG can be used as a novel and extremely useful resist material for generating both positive and negative structures in the context of DPN. In some embodiments, the PEG resist, when coupled with wet chemical etching, allows one to generate solid-state nanostructures in a manner that overcomes some of the limitations of the alkanethiol-based etching methods. Specifically, in some embodiments, the polymer-based approach requires only a simple washing step to desorb materials from a substrate surface and, in principle, can be used with many types of underlying substrates (there is no requirement of chemisorption). Furthermore, in some embodiments, the ability to generate a thick polymer layer and the elimination of the electrochemical desorption step associated with SAMs, results in less pitting of the surface due to pinholes. Finally, in some embodiments, the process works with parallel pen arrays allowing one to pattern over relatively large areas, and it is likely extendable to other polymeric materials and perhaps other lithographic techniques.

### BRIEF DESCRIPTION OF THE DRAWINGS

Figure 1 is a cross-sectional view of a substrate at different stages in the process of forming nanostructures thereon including a scheme showing the procedure using DPN printing to generate for example PEG nanopatterns and further exposing to etching solution to obtain (A) positive and (B) negative Au nanopattems.
Figure 2-5 show SEM (Figs. 2-4) and optical microscopy images of Au nanostructures generated using PEG as a positive (2,3) as well as negative (4,5) etching resist.
Figure 6. is an image of the nanoscale Northwestern University logo generated by first Dip pen printing of PEG molecules on Au substrate, followed by an etch step in solution.
Figure 7. Polymer-based etch-resist methodology for generating positive and negative nanostructures.
Figure 8. Contact mode AFM images of polyethylene glycol (A) line and (B) dot nanostructures generated using DPN.
Figure 9. (A) SEM and (B) optical microscopy images of the generated positive Au nanostructures ; (C) contact mode AFM image of PEG patterns used as etch resist to make the dot features in (D) ; (D) tapping mode AFM images of positive dot solid-state Au nanostructures generated from (C). One cell, which is designated by the white box in (A), is shown schematically in the inset of (A). Inset in D shows a zoomed-in AFM image of generated Au dot array.
Figure 10. (A) An SEM image of a set of positive nanostructures in the form of the Northwestern University logo; the expanded area is a representation of the dot matrix map used to generate the structure; (B) SEM image of positive line structures generated by DPN with the PEG resist and subsequent wet chemical etching; C) Tapping mode AFM image of the nanostructures shown in B and its corresponding height profile.
   Figure 11. Tapping mode AFM, height profile, and optical images of (A, C) circular holes and (B, D) line trenches generated using the negative feature polymer-based etching methodology. Inset in (A, B) shows the zoomed in AFM image of the negative nanostructures.

### DETAILED DESCRIPTION

Present embodiments provide a facile and novel method for forming nanostructures and microstructures by patterning and etching a substrate surface.

Description of micro fabrication, microstructures, nanofabrication and nanostructures is found for example in Madou, Fundamentals of Microfabrication, 2nd Ed., CRC, 2002.
For example, chapter one describes lithography.

### PRINTING METHODS

Nanolithography instrumentation can be obtained from NanoInk, Chicago, IL or a conventional AFM instrument can be used. Direct-write methods are described in Direct-Write Technologies for Rapid Prototyping Applications, Ed. By Pique and Chrisey, 2002. See for example Chapter overview and Chapter 10 for tip-based methods.

According to the invention, a substrate surface is patterned using a nanoscopic tip For example, Dip Pen Nanolithography printing techniques, which are described in various literature may be used.

For a more detailed description of Dip Pen Nanolithography printing, see, for example, US Pat. Nos. 6,827,979; 6,635,311; and 7,102,656 as well published US appl. 20050191434A1. Etching is described in for example US Patent Publications 200610014001 to Mirkin, et al. and 200610081479 to Mirkin et al. These references describe for example patterning, substrates, patterning compounds, and etching. Patterning compounds can be transferred from tip to substrate.

The nanoscopic tip can be a scanning probe microscopy (SPM) tip, an atomic force microscopy (AFM) tip, a solid tip or a hollow tip. A channel can be present to conduct the patterning compound to the distal end of a tip.

In the context of tip based transfer methods, the substrate surface may be patterned by applying a patterning composition to the tip, and delivering said composition from said tip to the substrate surface.

Other methods include those described in for example US Patent Publication Nos. 2004/0228962 (Liu, Mirkin et al.) and 2004/0226464 (Mirkin, Zhang) for scanning probe contact printing.

### PATTERNING COMPOSITION

According to the invention, the patterning composition comprises an oligomeric or polymeric compound.

The oligomeric or polymeric compound comprises a hetero atom in the backbone such as, for example, an oxygen atom or a nitrogen atom.
The backbone can function as a Lewis Base, and may or may not be linear. Preferably the oligomeric or polymeric compound comprises a polyether. Non-limiting examples of polyethers include polyalkylene oxides, polyalkylene glycols, and the like. Specifically, polyethylene oxide (PEO), polyethylene glycol (PEG) and polypropylene glycol (PPG) may be used.

The melting temperature of a suitable oligomeric or polymeric compound, when present, can vary, and may form a basis for selection of the compounds. For example, compounds may be chosen with a melting below about 60° C so that in higher humidities the material flows well off of a tip to a substrate.

In general, the oligomeric or polymeric compound can have good solubility, compatible with water and organic solvents including polar and nonpolar solvents, good or reasonable transfer rates from tip to substrate, and form stable patterns in etching environment. The oligomeric or polymeric compound is preferably water soluble. It is also preferable that the formed pattern which comprises said oligomer or polymer, can be washed away with one or more rinses with water. Alternatively, the oligomer or polymer can be soluble in organic solvents such as for example dichloromethane. The oligomer or polymer can be soluble in both water and at least one organic solvent.

The molecular weight of the polymeric or oligomeric compound may vary. For example, the molecular weight may be between about 100 and about 1,000,000 or between about 500 and about 500,000 or between about 500 and about 100,000 or between about 1,000 and about 50,000 or between about 1,000 and about 10,000, or about 1,000 and 5,000, or about 1,000 and 3,000. In general, lower molecular weight compounds can facilitate faster transfer from tip to substrate.

Oligomers and polymers can be used as known to one skilled in the art of polymer chemistry. See for example Allock, Contemporary Polymer Chemistry, 1981; and Billmeyer, Textbook of Polymer Science, 3rd Ed., 1984.

Another compound that may be used to pattern a substrate surface include for example, polyethylene imine.

Patterning can be carried out at various humidity levels. For example, higher relative humidities such as at least 40%, or at least 60%, or at least 80% may be used. In some cases relative humidity of about 80% shows fast compound transfer rate from an AFM probe tip to a substrate.

Patterning conditions can be selected so that a good organic solvent solution can be used to coat evenly a tip surface.

### SUBSTRATE

The substrate surface can be a surface of any substrate although the surface can be adapted to function with the patterning composition and the application at hand. Substrates are generally preferred for providing high resolution patterns. For example, the substrate surface can be a surface of an insulator such as, for example, glass or a conductor such as, for example, metal, including gold. In addition, the substrate can be a metal, a semiconductor, a magnetic material, a polymer material, a polymer-coated substrate, or a superconductor material. The substrate can be previously treated with one or more adsorbates. Still further, examples of suitable substrates include but are not limited to, metals, ceramics, metal oxides, semiconductor materials, magnetic materials, polymers or polymer coated substrates, superconductor materials, polystyrene, and glass. Metals include, but are not limited to gold, silver, aluminum, copper, platinum and palladium. Other substrates onto which compounds may be patterned include, but are not limited to silica, silicon oxide SiOₓ, GaAs, InP and InAs.

One of the advantages of the present method is that it does not require for a substrate surface to be chemical or physical modified prior to forming the pattern. Accordingly, in some embodiments, the substrate surface can be an unmodified substrate surface, i.e. a substrate surface, which was not chemically or physically modified prior to being patterned.

The chemical or physical medication of the substrate surface is usually used in the prior art methods to promote ink transport from the tip or stamp to the substrate surface, to enhance ink adhesion to the substrate surface or to covalently modify the substrate surface. Examples of physical or chemical modification of the substrate surface include but not limited to base treatment of a charged surface of silicon oxide, silanization with amino or mercaptosilinizing agents or modification with polymers carrying chemically reactive groups.

Another advantage of the present method is that it does not require prepatterning of the substrate surface.

The substrate can be monolithic, or comprise multiple materials including multiple layers. In a preferred embodiment, the substrate surface is a semiconductor or metal substrate surface.

The substrate surface can comprise conductive portions, insulative portions, or both. The conductive portions can be electrodes for example. The patterning composition can be used for example to form an etch resist for eventually fabricating electrodes or to modifying existing electrodes.

### INTERACTION BETWEEN SUBSTRATE AND PATTERNING COMPOSITION

In one embodiment, the patterning composition is weakly bonded to the substrate surface.
The patterning composition physisorbs to the substrate surface. As used herein "physisorb" denotes an interaction that does not involve substantial chemisorption or covalent linkage. A physiosorbed patterning compound can be removed from the substrate surface with a suitable solvent.

### ETCHING

The present embodiments relate to both positive and negative etching. In the present embodiments, the pattern(s) formed on a substrate surface function(s) an etch resist. In the preferred embodiments, said pattern(s) function(s) as a wet chemical etch resist. However, certain embodiments may include a non-wet etching step.

### MICROSTRUCTURES AND NANOSTRUCTURE ARRAYS

The nanostructures and microstructures formed according to embodiments of the present invention can be comparable to those formed using alkyl thiol molecules as etching resist, in terms of both the etching quality and the resolution of features.

For example, dots and lines can be prepared. Lines can be straight or curved. Lateral dimensions such as line width and diameter can be for example about 10 microns or less, or about one micron or less, or about 500 nm or less, or about 250 run or less, or about 100 nm or less. Minimum lateral dimension can be for example about 2 nm or about 5 nm or about 10 nm.

### WORKING EXAMPLES

The embodiments claimed herein are further illustrated with the use of non-limiting working examples.

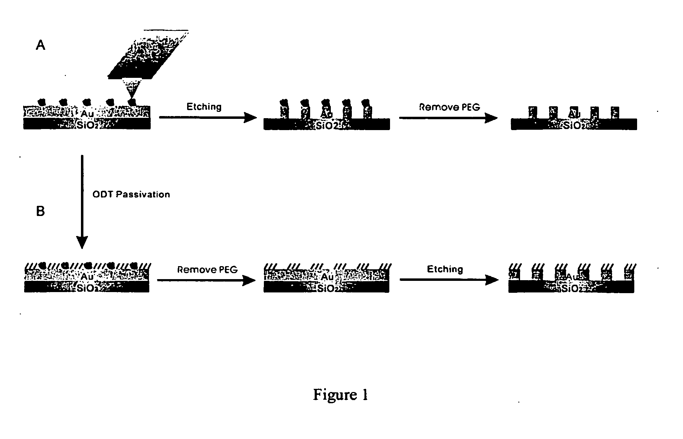

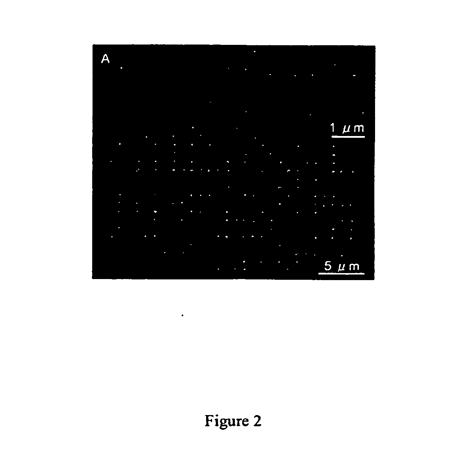

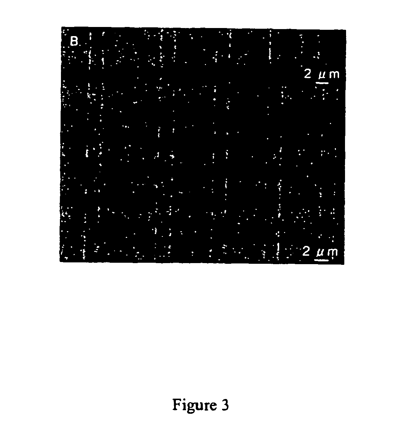

An embodiment is shown in Fig. 1A, where PEG is first patterned on Au surface via DPN printing, then the sample is exposed to the etching solution (thiourea : iron nitrate = 2:3, mol ratio) for a certain time. The PEG uncovered Au area (exposed substrate) is thereby etched away, while PEG here prevents the etching solution from contacting the Au area underneath and thus leaves the PEG covered area untouched. Finally, when PEG is washed away by simple water rinse, the positively etched Au nanostructures are formed (Fig. 2 and 3).

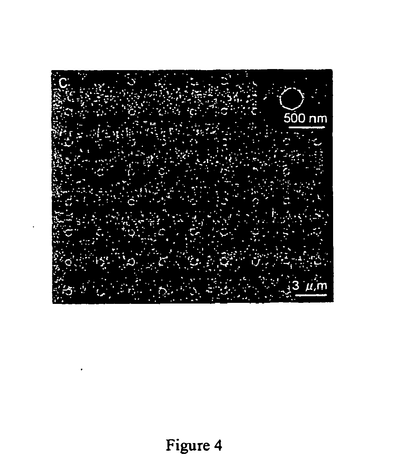

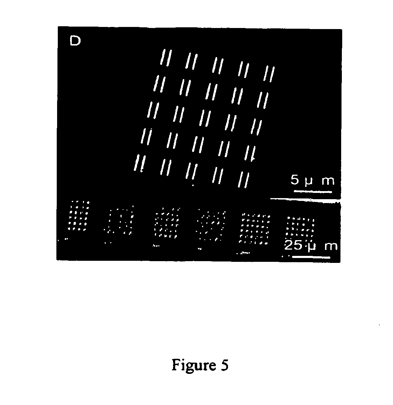

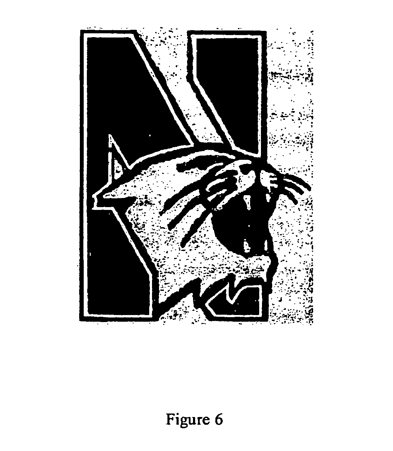

Alternatively, as shown in Fig. 1B, if one backfills the PEG uncovered area with ODT after DPN, then wash away the PEG, following exposing the sample into the same etching solution, a negatively etched nanostructures is formed (Fig. 4 and 5). Various shapes of Au architectures at the nano-scale can be generated via this simple method, where PEG works as both a positive and negative etching resist. This method is easy to employ, and arbitrarily designed nano-scale features can be obtained accordingly with high quality (Fig. 6). A further benefit is that this method does not require any electrochemical facility or further control experiments, although such methods could be coupled with these methods if desired.

### ADDITIONAL EMBODIMENTS

Dip-pen nanolithography (DPN)[1, 2] has emerged as a powerful tool for printing soft and hard matter on surfaces with sub-50 nm to many micrometer resolution. Indeed lithographic patterns of various small organic molecules,[3-5] polymers,[6-8] proteins,[9-12] sol gels,[13] nanoparticles,[14, 15] high melting temperature molecules, [16] and viruses [17] have been generated on a wide variety of substrates, including Au,[2, 18, 19] Ag,[20] GaAs,[21 and SiOx.[4, 22] With the development of cantilever arrays (linear A-26 pen[23] and 2D 55,000 pen array systems[24]) the technique has evolved into a parallel methodology[25] that, in certain cases, exceeds the throughput capabilities of serial nanolithographic techniques such as e-beam lithography. Indeed, it has been shown that by using a 2D 55,000 pen array in conjunction with wet-chemical etching protocols, one can generate millions of solid-state nanostructures over a square centimeter area in less than 30 min.[24]

A variety of etching protocols in combination with etch resist materials have been utilized to generate solid-state metal structures for applications in electronics, catalysis, and optics.[26] For example, alkanethiols have been used extensively as etching resists because they form self assembled monolayers (SAMs) that can protect an underlying metal surface from chemical or electrochemical oxidation and dissolution.[27-31] In fact, alkanethiols as DPN inks combined with wet-chemical or electrochemical etching protocols have been used to produce solid-state nanostructures with feature sizes ranging from 12 nm to many microns.[30-33] Typically, lithographic patterns of 1-octadecanethiol (ODT) or 16-mercaptohexadecanoic acid (MHA) are generated via DPN. Exposing the substrate containing the alkanethiol SAMs to etching solutions produces positive solid-state nanostructures. On the other hand, hole features (negative nanostructures) can be generated through the fabrication of MHA lithographic features using DPN, subsequently backfilling the exposed gold regions with ODT, electrochemically desorbing the MHA SAMs, and incubating the substrate in an etching solution. [33]

Although alkanethiols can be excellent etch resist materials for many surfaces (e.g., Au, Pd, and Ag), they possess certain limitations. In generating negative features, two different SAMs are required (e.g. ODT and MHA), and an electrochemical set-up can be necessary to selectively desorb one SAM in the presence of the other.[33, 34] Pinholes can lead to nonuniform etching and lower quality structures. Finally, one can use chemical protocols to eliminate the SAM resist from the surface once the desired solidstate structures have been made.

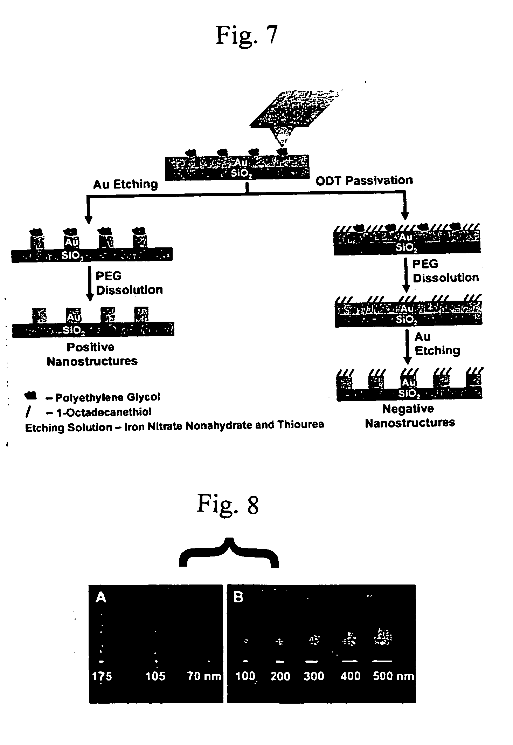

Herein, it is shown how polyethylene glycol (PEG), coupled with the high-resolution of DPN and wet-chemical etching methods, can be used as a novel physisorbed resist to generate high quality positive and negative nanostructures (Figure 7). Elimination of the resist can be effected by simply rinsing the patterned substrate in dichloromethane.

DPN templates of PEG features are used either as a protective or sacrificial layer to generate raised or recessed structures on surfaces, Figure 7. Derivatives of this polymer have been used as materials to minimize non-specific adsorption of proteins and virus particles on surfaces such as Au and SiO2.[9, 35-37] In a typical experiment, a cantilever array with 26 tips (A-26) was dipped into a 5 mg/ml acetonitrile solution of PEG (MW 2,000) for 10 sec, then mounted onto an NSCRIPTOR^{™} instrument, and used to generate dots and lines on gold surfaces. Incubating the substrate in an aqueous etching solution containing 20 mM thiourea and 30 mM iron nitrate monohydrate generates positive solid-state nanostructures, Figure 7A. On the other hand, substrates that were subsequently passivated with 1 mM ODT and washed with dichloromethane (to remove the PEG) before exposing to the same etching solution were used to produce negative nanoscale features, Figure 7B. The resulting nanostructures were characterized by atomic force microscopy (AFM), scanning electron microscopy (SEM), and optical microscopy.

One of the attributes of DPN is the ability to tailor feature size by varying the scan rate of the tip array and tip-substrate contact time. There is sometimes a feature size dependence that correlates with the square root of tip-substrate contact time.[16, 38-40] The PEG exhibits a similar dependence when deposited on a 30 nm thick Au film thermally evaporated on a SiO2 substrate. Scan rates of 0.05, 0.10, and 0.75 µm/sec gave 175, 105, and 70 nm wide line features, respectively, Figure 8A. On the other hand, dot features can be generated by holding the tip in contact with the substrate for set periods of time. Contact times of 0.5, 1, 2, 4, and 8 sec at 80-90% humidity resulted in dot features with diameters of 100, 200, 300, 400, and 500 nm, respectively, Figure 8B.

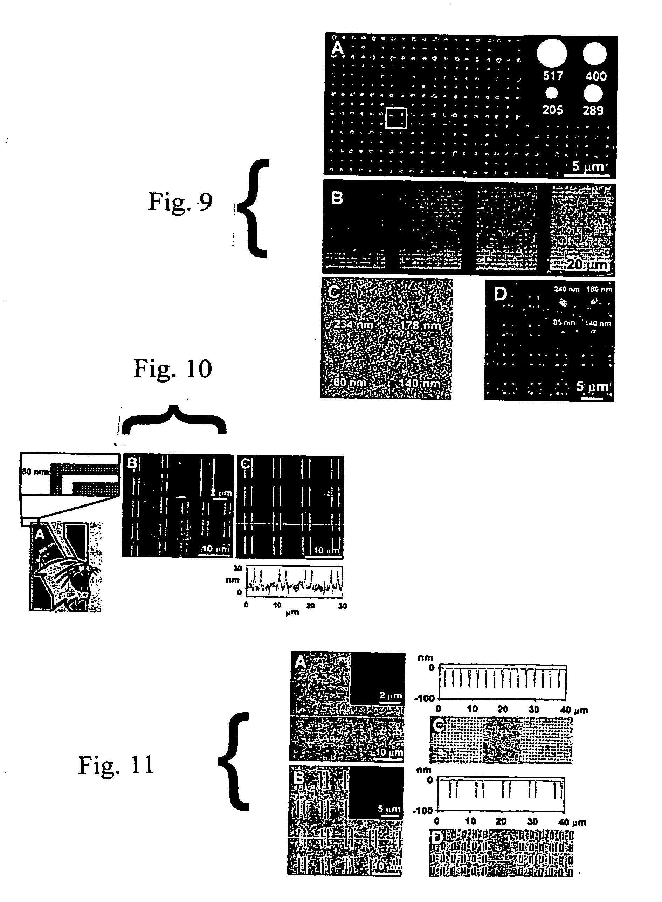

In addition to working out the protocol for patterning PEG, the potential for using the PEG resist and wet chemical etching to generate positive solid-state features was evaluated. A 26-pen parallel array was used to generate twenty six 15 x 20 PEG dot arrays on a gold thin film surface. Each array consists of dots with deliberately generated 200, 300, 400 and 500 nm diameter features. The total time needed to generate the 26 identical PEG dot arrays was about 1 hr. The patterned substrate was subsequently etched using an aqueous solution of 20 mM thiourea and 30 mM iron nitrate monohydrate to generate positive Au nanostructures with dot diameters of 205, 289, 400, and 517 nm (± 10 nm), respectively, Figure 9A-B. Significantly, one can reduce the PEG feature size to the sub-100 nm scale simply by reducing the humidity to about 70%. For example, contact times of 1, 2, 4, and 8 sec resulted in PEG dot features with diameters of 80, 140, 178, and 234 nm, respectively (Figure 9C). It was further shown that Au feature size down to 85 nm thus far can be sequentially obtained using the above generated PEG features as the etch resist (Figure 9D). There is remarkably good agreement between the sizes of the PEG resist features defined by DPN and the resulting solid-state raised nanostructures. AFM analysis of the solid-state features shows that on average they are 27 nm (± 2 nm) high, which is equivalent to the thickness of the evaporated Au layer (about 30 nm). These observations suggest that the PEG templates effectively protect the underlying gold regions, while the exposed gold areas were oxidized by the etching solution.

The DPN technique coupled with the novel PEG resist is quite versatile and allows one to generate very sophisticated structures, including complex shapes and patterns. As further demonstration, a digitized image was used of the Northwestern University logo, and a PEG replica of it at 80 nm dot size resolution in dot matrix form (about 12,000 features) was generated on an Au thin film substrate in 50 min. This structure was etched as described above for 45 min, rinsed with dichloromethane, and characterized by SEM (Figure 10A). Line arrays were similarly made, and SEM and AFM analyses postetching show the high uniformity and well-defined edges of the resulting features (Figure 10B-C). Each line, based upon AFM analysis (Fig. 10C-D) is 150 nm (± 5 nm) wide, 6 µm long, and 27 nm (± 2 nm) thick.

Interestingly, the PEG not only can be used to generate positive features but also negative ones. To generate negative features, the PEG was used as a sacrificial template (Figure 7B). With this approach, features were generated made of PEG by DPN on a 60-70 nm thick Au film, passivate the surrounding areas with ODT by immersing the substrate for 15 min in a 1 mM ethanolic solution of ODT, and then rinse with CH2Cl2 which removes the PEG and residual physisorbed ODT. Subsequent etching results in the formation of negative features in the areas originally occupied by PEG. Using this approach, arrays of dot and line features were generated, and AFM and optical analysis of the resulting structures show that they are highly uniform (4% variation in line width, 7% variation in dot diameter) (Figure 11). Height profiles show that the average depths of the generated nanostructures were similar to the thickness of the underlying gold layer (dots: about 65 nm, lines: about 58 nm). Different Au film thicknesses (70 nm for dot and 60 nm for line, Fig. 11A and B) can be used to evaluate the versatility of the technique and how one can control the depth of negative features using this approach. As with the positive features, the use of the cantilever arrays shows how the process can be easily scaled (Figure 11C and 11D).

### Experimental Section

PEG templates were generated using DPN. A-26 tip-array AFM probe was dip-coated in a 5 mg/ml polyethylene glycol acetonitrile solution for 10 seconds. The polymer coated cantilever probes were then mounted on an NSCRIPTOR^{™}, and polyethylene glycol features were written on a thin layer of Au thermally evaporated on a SiO2 substrate with a 10 nm Cr adhesion layer. PEG templates that were first passivated with 1 mM 1-octadecanethiol for 15 min and rinsed with a dichloromethane solution, prior to incubation in an etching solution containing 20 mM thiourea and 30 mM iron nitrate nonahydrate, were used to generate negative nanostructures. Positive solid-state nanostructures were generated upon direct incubation of the substrate in the same aqueous etching solution. The substrates were then rinsed with copious amounts of water to remove the PEG.
[1] D. S. Ginger, H. Zhang, C. A. Mirkin, Angew. Chem. 2004, 116, 30-46; Angew. Chem. Int. Ed. 2004, 43, 30-45.
[2] R. D. Piner, J. Zhu, F. Xu, S. H. Hong, C. A. Mirkin, Science 1999, 283, 661-663.
[3] X. Liu, S. Guo, C. A. Mirkin, Angew. Chem. 2003, 115, 4933-4937; Angew. Chem. Int. Ed. 2003, 42, 4785-4789.
[4] H. Jung, R. Kulkarni, C. P. Collier, J. Am. Chem. Soc. 2003, 125, 12096-12097.
[5] P. E. Sheehan, L. J. Whitman, W. P. King, B. A. Nelson, Appl. Phys. Lett. 2004, 85, 1589.
[6] J.-H. Lim, C. A. Mirkin, Adv. Mater. 2002, 14, 1474-1477.
[7] X. Liu, Y. Zhang, D. K. Goswami, J. S. Okasinski, K. Salaita, M. J. Bedzyk, C. A. Mirkin, Science 2004, 307, 1763-1766.
[8] A. Noy, A. E. Miller, J. E. Klare, B. L. Weeks, B. W. Woods, J. J. De Yoreo, Nano Lett. 2002, 2, 109-112.
[9] K.-B. Lee, S.-J. Park, C. A. Mirkin, J. C. Smith, M. Mrksich, Science 2002, 295, 1702-1705.
[10] H. Jung, C. K. Dalal, S. Kuntz, R. Shah, C. P. Collier, Nano Letters 2004, 4, 2171-2177.
[11] B. Li, Y. Zhang, J. Hu, M. Li, Ultramicroscopy 2005, 105, 312-315.
[12] J.-H. Lim, D. S. Ginger, K.-B. Lee, J. Heo, J.-M. Nam, C. A. Mirkin, Angew. Chem. 2003, 115, 2411-2114; Angew. Chem. Int. Ed. 2003, 42, 2309-2312.
[13] M. Su, X. Liu, S.-Y. Li, V. P. Dravid, C. A. Mirkin, J. Am. Chem. Soc. 2002, 124, 1560-1561.
[14] X. Liu, L. Fu, S. Hong, V. P. Dravid, C. A. Mirkin, Adv. Mater. 2002, 14, 231-234.
[15] N. S. John, G. Gundiah, P. J. Thomas, G. U. Kulkarni, Int. J. Nanosci. 2005, 4, 921-934.
[16] L. Huang, Y.-H. Chang, J. J. Kakkassery, C. A. Mirkin, J. Phys. Chem. B 2006, 110, 20756-20758
[17] R. A. Vega, D. Maspoch, K. Salaita, C. A. Mirkin, Angew. Chem. 2005, 117, 6167-6169; Angew. Chem. Int. Ed. 2005, 44, 6013-6015.
[18] S. Hong, C. A. Mirkin, Science 2000, 288, 1808-1811.
[19] S. Hong, J. Zhu, C. A. Mirkin, Science 1999, 286, 523-525.
[20] H. Zhang, R. Jin, C. A. Mirkin, Nano Lett. 2004, 4, 1493-1495.
[21] A. Ivanisevic, C. A. Mirkin, J. Am. Chem. Soc. 2001, 123, 7887-7889.
[22] D. J. Pena, M. P. Raphael, J. M. Byers, Langmuir 2003, 19, 9028-9032.
[23] K. Salaita, S. W. Lee, X. Wang, L. Huang, T. M. Dellinger, C. Liu, C. A. Mirkin, Small 2005, 1, 940-945.
[24] K. Salaita, Y. Wang, J. Fragala, R. A. Vega, C. Liu, C. A. Mirkin, Angew. Chem. 2006, 118, 7378-7381; Angew. Chem. Int. Ed. 2006, 45, 7220-7223.
[25] M. Zhang, D. Bullen, S. W. Chung, S. Hong, K. S. Ryu, Z. F. Fan, C. A. Mirkin, C. Liu, Nanotechnology 2002, 13, 212-217.
[26] J. C. Love, K. E. Paul, G. M. Whitesides, Adv. Mater. 2001, 13, 604.
[27] J. C. Love, L. A. Estroff, J. K. Kriebel, R. G. Nuzzo, G. M. Whitesides, Chem. Rev. 2005, 105, 1103-1169.
[28] D. A. Weinberger, S. Hong, C. A. Mirkin, B. W. Wessels, T. B. Higgins, Adv. Mater. 2000, 12, 1600-1603.
[29] Y. Xia, X.-M. Zhao, E. Kim, G. M. Whitesides, Chem. Mater. 1995, 7,2323.
[30] H. Zhang, S.-W. Chung, C. A. Mirkin, Nano Lett. 2003, 3, 43-45.
[31] H. Zhang, C. A. Mirkin, Chem. Mater. 2004, 16, 1480-1484.
[32] J.-W. Jang, D. Maspoch, T. Fujigaya, C. A. Mirkin, Small 2007, 3, 600-605.
[33] K. S. Salaita, S. W. Lee, D. S. Ginger, C. A. Mirkin, Nano Lett. 2006, 6, 2493 -2498.
[34] Y. Zhang, K. Salaita, J.-H. Lim, K.-B. Lee, C. A. Mirkin, Langmuir 2004, 20, 962-968.
[35] K.-B. Lee, J.-H. Lim, C. A. Mirkin, J. Am. Chem. Soc. 2003, 125, 5588-5589.
[36] K. L. Prime, G. M. Whitesides, Science 1991, 252, 1164-1167.
[37] G. P. Lopez, H. A. Biebuyck, R. Harter, A. Kumar, G. M. Whitesides, J. Am. Chem. Soc. 1993, 115, 10774-10781.
[38] P. Manandhar, J. Jang, G. C. Schatz, M. A. Ratner, S. Hong, Phys. ReV. Lett. 2003, 90, 1155051-1155054.
[39] N. Cho, S. Ryu, B. Kim, G. C. Schatz, S. Hong, J. Chem. Phys. 2006, 124, 0247141-0247145.
[40] S. Rozhok, R. Piner, C. A. Mirkin, J. Phys. Chem. B 2003, 107, 751-757.

The following sixty embodiments are described in US priority provisional application serial no. 60/886,839 filed January 26, 2007.
1. A method of forming nanostructures or microstructures comprising the steps of:
   performing direct-write nanolithography to pattern a surface of a substrate with an oligomeric or polymeric compound to provide exposed substrate; and
   etching the exposed substrate on the patterned surface to form the nanostructures or microstructures.
2. The method of embodiment 1 further comprising the step of removing the oligomeric or polymeric compound from the nanostructures.
3. The method of embodiment 1 wherein the oligomeric or polymeric compound comprises a water soluble oligomer or polymer.
4. The method of embodiment 1 wherein the oligomeric or polymeric compound comprises a heteroatom in the backbone.
5. The method of embodiment 4 wherein the oligomeric or polymeric compound comprises an oxygen atom which acts as a Lewis Base.
6. The method of embodiment 4 wherein the oligomeric or polymeric compound comprises polyethyleneglycol (PEG).
7. The method of embodiment 4 wherein the oligomeric or polymeric compound comprises polyethylene oxide.
8. The method of embodiment 1 wherein the substrate comprises a metal, a semiconductor or an insulator material.
9. The method of embodiment 1 wherein the substrate comprises a metal layer on an insulator.
10. The method of embodiment 9 wherein the substrate comprises a layer of gold on silicon oxide.
11. A method of forming nanostructures or microstructures comprising the steps of:
   performing microcontact printing to pattern the surface of a substrate with an oligomeric or polymeric compound and provide an exposed substrate; and
   etching the exposed substrate on the patterned surface to form the nanostructures or microstructures.
12. The method of embodiment 11 further comprising the step of removing the oligomeric or polymeric compound from the nanostructures or microstructures.
13. The method of embodiment 11 wherein the polymeric compound comprises a water soluble oligomer or polymer.
14. The method of embodiment 11 wherein the oligomeric or polymeric compound comprises a heteroatom.
15. The method of embodiment 14 wherein the oligomeric or polymeric compound comprises an oxygen atom which acts as a Lewis Base.
16. The method of embodiment 14 wherein the oligomeric or polymeric compound comprises polyethyleneglycol (PEG).
17. The method of embodiment 14 wherein the oligomeric or polymeric compound comprises polyethylene oxide.
18. The method of embodiment 11 wherein the substrate comprises a metal, a semiconductor or an insulator material.
19. The method of embodiment 11 wherein the substrate comprises a metal layer on an insulator.
20. The method of embodiment 19 wherein the substrate comprises a layer of gold on silicon oxide.
21. A method of forming nanostructures or microstructures comprising the steps of:
   performing direct-write nanolithography to pattern a surface of a substrate with an oligomeric or polymeric compound;
   coating the non-patterned region of the substrate surface with a passivating compound;
   removing the oligomeric or polymeric compound to provide exposed substrate; and
   etching the exposed substrate to form nanostructures or microstructures.
22. The method of embodiment 21 further comprising the step of removing passivating compound.
23. The method of embodiment 21 wherein the passivating compound comprises a thiol compound.
24. The method of embodiment 23 wherein the passivating compound comprises octadecyl thiol (ODT).
25. The method of embodiment 21 wherein the oligomeric or polymeric compound comprises a water soluble polymer.
26. The method of embodiment 21 wherein the oligomeric or polymeric compound comprises a heteroatom.
27. The method of embodiment 26 wherein the oligomeric or polymeric compound comprises an oxygen atom which acts as a Lewis Base.
28. The method of embodiment 26 wherein the oligomeric or polymeric compound comprises polyethyleneglycol (PEG).
29. The method of embodiment 26 wherein the oligomeric or polymeric compound comprises polyethylene oxide.
30. The method of embodiment 21 wherein the substrate comprises a metal, a semiconductor or an insulator material.
31. The method of embodiment 21 wherein the substrate comprises a metal layer on an insulator.
32. The method of embodiment 31 wherein the substrate comprises a layer of gold on silicon oxide.
33. A method of forming nanostructures or microstructures comprising the steps of:
   performing microcontact printing to pattern the surface of a substrate with an oligomeric or polymeric compound;
   coating the non-patterned region the substrate surface with a passivating compound;
   removing the oligomeric or polymeric compound and provide exposed substrate; and
   etching the exposed substrate to form nanostructures or microstructures.
34. The method of embodiment 33 further comprising the step of removing the passivating compound.
35. The method of embodiment 33 wherein the passivating compound comprises a thiol compound.
36. The method of embodiment 35 wherein the passivating compound comprises octadecyl thiol (ODT).
37. The method of embodiment 33 further comprising the step of removing remaining oligomeric or polymeric compound.
38. The method of embodiment 33 wherein the oligomeric or polymeric compound comprises a water soluble oligomer or polymer.
39. The method of embodiment 33 wherein the oligomeric or polymeric compound comprises a heteroatom.
40. The method of embodiment 39 wherein the oligomeric or polymeric compound comprises an oxygen atom which acts as a Lewis Base.
41. The method of embodiment 39 wherein the oligomeric or polymeric compound comprises polyethyleneglycol (PEG).
42. The method of embodiment 39 wherein the oligomeric or polymeric compound comprises polyethylene oxide.
43. The method of embodiment 39 wherein the substrate comprises a metal, a semiconductor or an insulator material.
44. The method of embodiment 33 wherein the substrate comprises a metal layer on an insulator.
45. The method of embodiment 44 wherein the substrate comprises a layer of gold on silicon oxide.
46. An array of nanostructures formed according to any one of embodiments 1-45.
47. An array of microstructures formed according to any one of embodiments 1-45.
48. An article comprising a nanostructure formed on a substrate, wherein said nanostructure comprises a metal and said substrate comprises an insulator.
49. The article of embodiment 48 wherein said nanostructure comprises gold.
50. The article of embodiment 48 wherein the substrate comprises silicon oxide.
51. The article of embodiment 48 wherein the nanostructure is formed by direct-write nanolithography and etching of a metal layer.
52. An article comprising a microstructure formed on a substrate, wherein said microostructure comprises a metal and said substrate comprises an insulator, and wherein the microostructure is formed by microcontact printing and etching of a metal layer.
53. A method of forming nanostructures or microstructures comprising the steps of:
   performing direct-write nanolithography to pattern a surface of a substrate with an oligomeric or polymeric compound to provide exposed substrate, wherein patterning comprises transfer of the oligomeric or polymeric compound from a tip to the surface of the substrate; and
   etching the exposed substrate on the patterned surface to form the nanostructures or microstructures.
54. The method of embodiment 53, wherein the tip is a scanning probe microscope tip.
55. The method of embodiment 53, wherein the tip is an atomic force microscope tip.
56. The method of embodiment 53, wherein the tip is a hollow tip.
57. A method of forming nanostructures or microstructures comprising the steps of:
   performing direct-write nanolithography to pattern a surface of a substrate with an oligomeric or polymeric compound, wherein the oligomeric or polymeric compound is transferred from a tip to the surface of the substrate;
   coating the non-patterned region of the substrate surface with a passivating compound;
   removing the oligomeric or polymeric compound to provide exposed substrate; and
   etching the exposed substrate to form nanostructures or microstructures.
58. The method of embodiment 57, wherein the tip is a scanning probe microscope tip.
59. The method of embodiment 57, wherein the tip is an atomic force microscope tip.
60. The method of embodiment 57, wherein the tip is a hollow tip.

This concludes the sixty embodiments.

## Claims

1. A method of forming nanostructures or microstructures comprising the steps of:
patterning a surface of a substrate with a patterning composition comprising an oligomeric or polymeric compound to provide an exposed substrate, wherein the oligomeric or polymeric compound comprises a heteroatom in the backbone, the patterning composition is physisorbed to the substrate surface, and patterning a surface of the substrate comprises transfer of the patterning composition from a nanoscopic tip to the surface of the substrate; and
etching the exposed substrate on the patterned surface to form the nanostructures or microstructures.

2. A method of forming nanostructures or microstructures comprising the steps of:
patterning a surface of a substrate with a patterning composition comprising an oligomeric or polymeric compound, wherein the oligomeric or polymeric compound comprises a heteroatom in the backbone, the patterning composition is physisorbed to the substrate surface, and patterning a surface of the substrate comprises transfer of the patterning composition from a nanoscopic tip to the surface of the substrate;
coating the non-patterned region of the substrate surface with a passivating compound;
removing the patterning composition to provide an exposed substrate; and
etching the exposed substrate to form nanostructures or microstructures.

3. The method of claim 1 or 2, wherein the oligomeric or polymeric compound of the patterning composition is water soluble.

4. The method of any one of the preceding claims, wherein the oligomeric or polymeric compound of the patterning composition is soluble in at least one organic solvent.

5. The method of claim 1 or 2, wherein the oligomeric or polymeric compound comprises an oxygen atom as a heteroatom in the backbone.

6. The method of claim 1 or 2, wherein the oligomeric or polymeric compound comprises a nitrogen atom as a heteroatom in the backbone.

7. The method of claim 1 or 2, wherein the oligomeric or polymeric compound comprises a polyether.

8. The method of claim 1 or 2, wherein the oligomeric or polymeric compound comprises a polyalkylene oxide or a polyalkylene glycol.

9. The method of claim 1 or 2, wherein the patterning composition comprises polyethyleneglycol (PEG) or polyethylene oxide (PEO).

10. The method of claim 1 or 2, wherein the patterning composition comprises polypropylene glycol.

11. The method of claim 1 or 2, wherein the oligomeric or polymeric compound has a melting point below 60° C.

12. The method of claim 1 or 2, wherein the tip is a scanning probe microscope tip, or wherein the tip is an atomic force microscope tip, or wherein the tip is a hollow tip, or wherein the tip is a non-hollow tip.

13. The method of claim 1 or 2, wherein patterning a surface of a substrate is carried out at a relative humidity of at least about 40%.

14. The method of claim 1 or 2, wherein the substrate surface is a semiconductor or metal substrate surface.

15. The method of claim 1 or 2, wherein the substrate surface comprises at least one of conductive portions and insulative portions.

## Patentansprüche

1. Verfahren zum Bilden von Nanostrukturen oder Mikrostrukturen umfassend die Schritte:
Strukturieren einer Oberfläche eines Substrats mit einer Strukturierungszusammensetzung umfassend eine oligomere oder polymere Verbindung um ein exponiertes Substrat bereit zu stellen, wobei die oligomere oder
polymere Verbindung ein Heteroatom im Gerüst umfasst, die Strukturierungszusammensetzung an der Substratoberfläche physisorbiert ist, und
Strukturieren einer Oberfläche des Substrats das Transferieren der Strukturierungszusammensetzung von einer nanoskopen Spitze auf die Oberfläche des Substrats umfasst; und
Ätzen des exponierten Substrats auf der strukturierten Oberfläche um Nanostrukturen oder Miktrostrukturen zu bilden.

2. Verfahren zum Bilden von Nanostrukturen oder Mikrostrukturen umfassend die Schritte:
Strukturieren einer Oberfläche eines Substrats mit einer Strukturierungszusammensetzung umfassend eine oligomere oder polymere Verbindung, wobei die oligomere oder polymere Verbindung ein Heteroatom im Gerüst umfasst, die Strukturierungszusammensetzung an der Substratoberfläche physisorbiert ist, und Strukturieren einer Oberfläche des Substrats das Transferieren der Strukturierungszusammensetzung von einer nanoskopen Spitze auf die Oberfläche des Substrats umfasst;
Beschichten des nicht-strukturierten Bereichs der Substratoberfläche mit einer passivierenden Verbindung;
Entfernen der Strukturierungszusammensetzung um ein exponiertes Substrat bereit zu stellen; und Ätzen des exponierten Substrats um Nanostrukturen oder
Mikrostrukturen zu bilden.

3. Verfahren nach Anspruch 1 oder 2, wobei die oligomere oder polymere Verbindung der Strukturierungszusammensetzung wasserlöslich ist.

4. Verfahren nach einem der vorhergehenden Ansprüche, wobei die oligomere oder polymere Verbindung der Strukturierungszusammensetzung in mindestens einem organischen Lösungsmittel löslich ist.

5. Verfahren nach Anspruch 1 oder 2, wobei die oligomere oder polymere Verbindung ein Sauerstoffatom als ein Heteroatom im Gerüst umfasst.

6. Verfahren nach Anspruch 1 oder 2, wobei die oligomere oder polymere Verbindung ein Stickstoffatom als ein Heteroatom im Gerüst umfasst.

7. Verfahren nach Anspruch 1 oder 2, wobei die oligomere oder polymere Verbindung einen Polyether umfasst.

8. Verfahren nach Anspruch 1 oder 2, wobei die oligomere oder polymere Verbindung ein Polyalkylenoxid oder ein Polyalkylenglykol umfasst.

9. Verfahren nach Anspruch 1 oder 2, wobei die Strukturierungszusammensetzung Polyethylenglycol (PEG) oder Polyethylenoxid (PEO) umfasst.

10. Verfahren nach Anspruch 1 oder 2, wobei die Strukturierungszusammensetzung Polypropylenglycol umfasst.

11. Verfahren nach Anspruch 1 oder 2, wobei die oligomere oder polymere Verbindung einen Schmelzpunkt unterhalb von 60 °C hat.

12. Verfahren nach Anspruch 1 oder 2, wobei die Spitze eine Rastersondenmikroskop-Spitze ist, oder wobei die Spitze eine Rasterkraftmikroskop-Spitze ist, oder wobei die Spitze eine hohle Spitze ist, oder wobei die Spitze eine nicht-hohle Spitze ist.

13. Verfahren nach Anspruch 1 oder 2, wobei das Strukturieren einer Oberfläche eines Substrats bei einer relativen Luftfeuchtigkeit von mindestens ungefähr 40% ausgeführt wird.

14. Verfahren nach Anspruch 1 oder 2, wobei die Substratoberfläche ein Halbleiter oder eine Metallsubstratoberfläche ist.

15. Verfahren nach Anspruch 1 oder 2, wobei die Substratoberfläche mindestens einen von leitfähigen Teilbereichen und nicht- leitfähigen Teilbereichen umfasst.

## Revendications

1. Procédé de formation de nanostructures ou de microstructures comprenant les étapes de :
- former un motif sur une surface d'un substrat avec une composition pour formation de motif comprenant un composé oligomère ou polymère pour fournir un substrat exposé, le composé oligomère ou polymère comprenant un hétéroatome dans la chaîne principale, la composition pour formation de motif étant adsorbée physiquement à la surface du substrat, et la formation du motif sur une surface du substrat comprenant le transfert de la composition pour formation de motif d'une pointe nanoscopique à la surface du substrat ; et
- graver le substrat exposé sur la surface à motif pour former les nanostructures ou microstructures.

2. Procédé de formation de nanostructures ou microstructures comprenant les étapes consistant à :
- former un motif sur une surface d'un substrat avec une composition pour formation de motif comprenant un composé oligomère ou polymère, le composé oligomère ou polymère comprenant un hétéroatome dans la chaîne principale, la composition pour formation de motif étant adsorbée physiquement à la surface du substrat, et la formation du motif sur une surface du substrat comprenant le transfert de la composition pour formation de motif d'une pointe nanoscopique à la surface du substrat ;
- revêtir la région sans motif de la surface du substrat avec un composé de passivation ;
- éliminer la composition pour formation de motif pour fournir un substrat exposé ; et
- graver le substrat exposé pour former les nanostructures ou microstructures.

3. Procédé selon la revendication 1 ou 2, dans lequel le composé oligomère ou polymère de la composition pour formation de motif est hydrosoluble.

4. Procédé selon l'une quelconque des revendications précédentes, dans lequel le composé oligomère ou polymère de la composition pour formation de motif est soluble dans au moins un solvant organique.

5. Procédé selon la revendication 1 ou 2, dans lequel le composé oligomère ou polymère comprend un atome d'oxygène en tant qu'hétéroatome dans la chaîne principale.

6. Procédé selon la revendication 1 ou 2, dans lequel le composé oligomère ou polymère comprend un atome d'azote en tant qu'hétéroatome dans la chaîne principale.

7. Procédé selon la revendication 1 ou 2, dans lequel le composé oligomère ou polymère comprend un polyéther.

8. Procédé selon la revendication 1 ou 2, dans lequel le composé oligomère ou polymère comprend un oxyde de polyalkylène ou un polyalkylène glycol.

9. Procédé selon la revendication 1 ou 2, dans lequel la composition pour formation de motif comprend du polyéthylèneglycol (PEG) ou de l'oxyde de polyéthylène (PEO).

10. Procédé selon la revendication 1 ou 2, dans lequel la composition pour formation de motif comprend du glycol polypropylénique.

11. Procédé selon la revendication 1 ou 2, dans lequel le composé oligomère ou polymère a un point de fusion inférieur à 60 °C.

12. Procédé selon la revendication 1 ou 2, dans lequel la pointe est une pointe de microscope-sonde à balayage, ou dans lequel la pointe est une pointe de microscope à force atomique, ou dans lequel la pointe est une pointe creuse, ou dans lequel la pointe est une pointe non creuse.

13. Procédé selon la revendication 1 ou 2, dans lequel la formation d'un motif sur une surface d'un substrat est réalisée à une humidité relative d'au moins environ 40 %.

14. Procédé selon la revendication 1 ou 2, dans lequel la surface du substrat est une surface de substrat semi-conducteur ou métallique.

15. Procédé selon la revendication 1 ou 2, dans lequel la surface de substrat comprend au moins une partie conductrice ou au moins une partie isolante.
